(19) Europäisches Patentamt
European Patent Office
Office européen des brevets

(11) Publication number: **0 076 656**
**B1**

(12) # EUROPEAN PATENT SPECIFICATION

(45) Date of publication of patent specification: **01.06.88**

(51) Int. Cl.$^4$: **C 08 G 77/20**, C 08 L 83/04, H 01 L 21/312, C 08 K 5/00

(21) Application number: **82305223.8**

(22) Date of filing: **30.09.82**

(54) **Solvent-soluble organopolysilsesquioxanes, processes for producing the same, and compositions and semiconductor devices using the same.**

(30) Priority: **03.10.81 JP 157885/81**
**22.10.81 JP 169178/81**
**30.11.81 JP 190667/81**

(43) Date of publication of application:
**13.04.83 Bulletin 83/15**

(45) Publication of the grant of the patent:
**01.06.88 Bulletin 88/22**

(84) Designated Contracting States:
**DE FR GB**

(56) References cited:
**DE-A-2 211 723**
**FR-A-1 472 047**
**FR-A-2 110 115**
**US-A-3 758 306**

**Chemical Abstracts, vol. 81, no. 12, 23 September 1974, Columbus, Ohio, USA, T. TAKIGUCHI et al. "Preparation of soluble poly(phenylsilsesquioxanes)", page 4, abstract no. 64024r**

(73) Proprietor: **JAPAN SYNTHETIC RUBBER CO., LTD.**
**11-24, Tsukiji-2-chome Chuo-ku**
**Tokyo 104 (JP)**

(72) Inventor: **Nozue, Ikuo**
**29, Aobadai-2-chome**
**Midori-ku Yokohama (JP)**
Inventor: **Tomomitsu, Osahiko**
**29, Aobadai-2-chome**
**Midori-ku Yokohama (JP)**
Inventor: **Yumoto, Yoshiji**
**29, Aobadai-2-chome**
**Midori-ku Yokohama (JP)**
Inventor: **Matsumura, Yoshio**
**1, Morigayamacho**
**Yokkaichi-shi (JP)**

(74) Representative: **Tubby, David George et al**
**MARKS & CLERK 57-60 Lincoln's Inn Fields**
**London WC2A 3LS (GB)**

**EP 0 076 656 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:
**Chemical Abstracts, vol. 83, no. 14, 6 October 1975, Columbus, Ohio, USA, J.C. DUBOIS et al. "Poly(vinylsiloxane) (PVS), a highly sensitive electron-beam resist", page 45, abstract no. 115553p**

**Chemical Abstracts, vol. 83, no. 14, 6 October 1975, Columbus, Ohio, USA, J.C. DUBOIS et al., "Poly(vinylsiloxane) (PVS), a highly sensitive electron-beam resist", page 45, abstract no. 115553p**

**POLYMER SCIENCE OF USSR, vol. 20, no. 1, 1978, V.T. KOZLOV et al. "Study of vulcanization by radiation of polyorganosiloxane elastomers in the presence of pore forming compounds", pages 248-253**

**Description**

This invention relates to a composition comprising a solvent-soluble polysilsesquioxane which has lower alkyl groups and alkenyl groups as side chains and has excellent heat resistance and a compound which generates a plurality of crosslinking-reaction-active species by irradiation with light or ionizing radiation. Such a composition may be used to produce a semiconductor device.

Polysilsesquioxanes having aryl groups (such as phenyl or tolyl groups) and solvent-soluble polysilsesquioxanes having alkyl groups (such as methyl, isobutyl or isoamyl groups) are known [J. Amer. Chem. Soc., *82*, 6194 (1960); J. Polymer Sci., Vol. C—1, 83 (1963); Vysokomol. Soyed., Vol. A12, 663 (1970); Izv. Akad. Nauk SSSR Ser Khim., 625 (1969); and JP—A—139,900/75 and 88,099/78). However, these have inferior heat resistance and adhesion to substrates.

G. H. Wagner *et al.* have synthesized a vinyl-polysilsesquioxane having a number average molecular weight of about 3,800 by hydrolyzing vinyltrichlorosilane in an ether [Ind. Eng. Chem., *45*, 367 (1953)]. This compound also has inferior heat resistance and low storage stability. Recently, Yamazaki *et al.* have obtained a polysilsesquioxane having a molecular weight of about 10,000 and having phenyl groups and vinyl groups or methacryl- or acryl- oxyalkyl groups as side chains by a two-step reaction comprising cohydrolyzing a vinyltrialkoxysilane or a methacryl- or acryl- oxyalkyltrialkoxysilane with a phenyltrialkoxysilane to give an oligomer with a molecular weight of about 1,000, and then subjecting the oligomer to a condensation reaction in the presence of an alkali catalyst [Preliminary Lectures in the 29th Annual Meeting of Polymer Society of Japan, *29*, No. 1, 73 (1980)]. However, the alkali catalyst remains in the polysilsesquioxane thus obtained and acts as a catalyst for depolymerization of the polysilsesquioxane at high temperatures; hence, sufficient heat resistance cannot be expected.

In the DE—A—2 211 723 liquid polyorganosiloxane compositions are disclosed which possess from 1,3 to 1,6 of organic substituents per silicon atom (polysilsesquioxanes have one organic substituent per silicon atom) and which are heat curable by the action of organic peroxides.

In Electron Ion Beam Sci. Technol. Int. Conf. *1972*, 5, 112—22 (Chem. Abs. *83*, 115 553p (1975)) polyvinylsiloxanes are disclosed which may comprise methyl substituents, the vinyl/methyl ratio being 8:2. The crosslinking behaviour of these polyvinylsiloxanes is different from that of polysilsesquioxanes having a maximum vinyl/alkyl ratio of 1:1.

The FR—A—1 472 047 discloses polyorganosiloxanes comprising vinyl and methyl substituents but without specifying organopolysilsesquioxanes having a particular alkylene/alkyl substituent ratio.

We have now discovered a solvent-soluble organopolysilsesquioxane having a high heat resistance and having alkenyl groups rich in reactivity as side chains.

Thus, the present invention provides a composition comprising:

(a) an organopolysilsesquioxane represented by the formula (I):

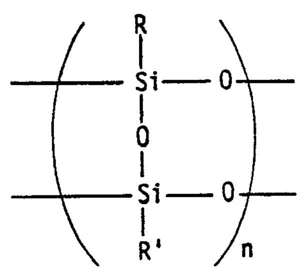

(I)

wherein R and R′, which may be the same or different, each represents a hydrogen atom, a $C_1$—$C_8$ alkyl group, an alkenyl group or an aryl group, and *n* is a degree of polymerisation, characterised in that some of the groups represented by R and/or R′ are $C_1$—$C_8$ alkyl groups, some of the groups represented by R and/or R′ are alkenyl groups and optionally other R and/or R′ represent aryl groups and/or hydrogen atoms and the proportions of said alkyl groups, alkenyl groups, aryl groups and hydrogen atoms bonded as side chains are from 50 to 99, from 1 to 50, from 0 to 49 and from 0 to 49, respectively, per 100 side chains and

(b) a compound which generates a cross-linking-reacting-active species upon irradiation with light or ionizing radiation.

The composition of the invention is hereinafter referred to as "the silicone resin composition".

In a process (A) for producing organopolysilsesquioxane, water is added to a solution of a $C_1$—$C_8$ alkyltrihalosilane, an alkenyltrihalosilane and, if necessary, an aryltrihalosilane and/or a trihalosilane in an organic solvent, and the resulting mixture is heated.

In a process (B) for producing the organopolysilsesquioxane, water is added in the presence of organic amine, to a solution of a $C_1$—$C_8$ alkyltrialkoxysilane, an alkenyltrialkoxysilane and, if necessary, an aryltrialkoxysilane and/or a trialkoxysilane in an organic solvent, and the resulting mixture is heated.

A semiconductor device having a patterned surface-protecting or insulating layer comprising the organopolysilsesquioxane crosslinked by irradiation with light or an ionizing radiation may be produced by forming a layer of the organopolysilsesquioxane or the silicone resin composition on the surface of a semiconductor device substrate, irradiating a part of the aforesaid layer with light or ionizing radiation to crosslink the irradiated portions and then removing the unirradiated portions.

This invention is also illustrated by the accompanying drawings, in which Figures 1 to 7 show infrared absorption spectra of organopolysilsesquioxanes obtained in Examples 1 to 7, respectively, Figures 8 to 10 are explanatory cross-sectional views showing in order the steps of the process for forming a pattern using the organopolysilsesquioxane of this invention and Figures 11 to 15 are explanatory cross-sectional views showing in order the steps of a process for producing a semiconductor device.

In the organopolysilsesquioxane used in this invention, the alkyl groups represented by R and/or R' preferably have from 1 to 5 carbon atoms, for example, a methyl group, an ethyl group, a propyl group or a butyl group; the alkyl groups represented by R and/or R' may be the same or different. The alkenyl groups represented by R and/or R' preferably have from 2 to 5 carbon atoms, for example, a vinyl group, a propenyl group, a butenyl group, a pentenyl group or an allyl group; the alkenyl groups represented by R and/or R' may be the same or different. The aryl groups which may be represented by R and/or R' preferably have from 6 to 10 carbon atoms, e.g. a phenyl group, a dimethylphenyl group, an ethylphenyl group, a trimethylphenyl group, a methylethylphenyl group, a propylphenyl group, a tetramethylphenyl group, a methylpropylphenyl group, a diethylphenyl group, a butylphenyl group or a tolyl group; these aryl groups may be the same or different.

The alkyl and alkenyl groups represented by R and/or R' are preferably methyl and vinyl groups, respectively, since, in the case of these groups, the organopolysilsesquioxane has particularly excellent heat resistance. Where some of the groups represented by R and/or R' are aryl groups, they are preferably phenyl groups in view of the ease of synthesis of the organopolysilsesquioxane.

In the organopolysilsesquioxane used in this invention, the numbers of $C_1$—$C_8$ alkyl groups, alkenyl groups, aryl groups and hydrogen atoms bonded as side chains per 100 side chains in total are preferably 50—99, 1—50, 0—49 and 0—49, respectively, more preferably 70—99, 1—30, 0—29 and 0—29, respectively. The presence of 50 or more $C_1$—$C_8$ alkyl groups per 100 side chains in total imparts to the resulting organopolysilsesquioxane better heat resistance, and the presence of at least 1 alkenyl group per 100 side chains in total imparts to the resulting organopolysilsesquioxane particularly excellent reactivity.

Examples of $C_1$—$C_8$ alkyltrihalosilanes which may be used in process (A) of this invention include methyltrichlorosilane, ethyltrichlorosilane, propyltrichlorosilane, butyltrichlorosilane and methyltribromosilane; examples of alkenyltrihalosilanes include vinyltrichlorosilane, propenyltrichlorosilane, butenyltrichlorosilane, pentenyltrichlorosilane, allyltrichlorosilane and vinyltribromosilane; examples of the optional aryltrihalosilanes include phenyltrichlorosilane, dimethylphenyltrichlorosilane, ethylphenyltrichlorosilane, trimethylphenyltrichlorosilane, methylethylphenyltrichlorosilane, propylphenyltrichlorosilane, tetramethylphenyltrichlorosilane, methylpropylphenyltrichlorosilane, diethylphenyltrichlorosilane, butylphenyltrichlorosilane, tolyltrichlorosilane and phenyltribromosilane; and examples of the optional trihalosilanes include trichlorosilane and tribromosilane.

The amounts of the alkyltrihalosilane, the alkenyltrihalosilane, the aryltrihalosilane and the trihalosilane used may be determined appropriately depending upon the proportions of the alkyl and alkenyl groups to be bonded as the side chains of the desired organopolysilsesquioxane and upon the proportions of the aryl groups and the hydrogen atoms which may optionally be bonded as side chains, but the amount of the alkyltrihalosilane used is preferably from 50 to 99 mole%, more preferably from 70 to 99 mole%, the amount of the alkenyltrihalosilane used is preferably from 1 to 50 mole%, more preferably from 1 to 30 mole%, the amount of the aryltrihalosilane used is preferably from 0 to 49 mole%, more preferably from 0 to 29 mole%, and the amount of the trihalosilane used is preferably from 0 to 49 mole%, more preferably from 0 to 29 mole%, the total being 100 mole%. The employment of an aryltrihalosilane sometimes further facilitates the synthesis of an organopolysilsesquioxane. The employment of a trihalosilane results in an improvement in physical or chemical properties of the organopolysilsesquioxane.

Suitable organic solvents include, for example: ketones, such as methyl ethyl ketone, diethyl ketone or methyl isobutyl ketone; ethers, such as ethylene glycol dimethyl ether, dipropyl ether, dioxane, diethylene glycol dimethyl ether or tetrahydrofuran; aliphatic hydrocarbons, such as heptane or octane; aromatic hydrocarbons, such as toluene or xylene; halogenated hydrocarbons, such as 1,2-dichloroethane, 1,1,2-trichloroethane, 1,3-dichloropropane or chlorobenzene; alcohols, such as propyl alcohol, butyl alcohol, isobutyl alcohol, hexyl alcohol or 4-methyl-2-pentanol; and esters, such as ethyl propionate, ethyl isobutyrate, isobutyl acetate, butyl acetate or isoamyl acetate. An organic solvent containing a ketone and/or an ether in an amount of 40 mole% or more, particularly 60 mole% or more, is preferred from the view-point of ease of synthesis of the desired organopolysilsesquioxane.

The amount of organic solvent used is preferably from 4 to 20 parts by volume of the sum of the alkyltrihalosilane, the alkenyltrihalosilane, the aryltrihalosilane and the trihalosilane used (these four silanes are hereinafter referred to as the "halosilanes").

The hydrolysis of the halosilanes is effected by adding water to a solution of the halosilanes in an organic solvent. In this case, in order to facilitate the control of the reaction, it is preferred to use a method in which the solution is cooled to, for example, 10° to 50°C and water is gradually added thereto with stirring. The amount of water used is preferably from 3 to 30 moles per mole of the sum of the halosilanes.

After the addition of water, the reaction mixture is heated, for example, on an oil bath to effect

condensation. The heating temperature is preferably 130°C or less, and it is more preferred to heat at from 70° to 110°C for from 1 to 6 hours.

During the condensation, the reaction mixture may be stirred or merely left to reflux.

When an amine is present when adding water to a solution of the halosilanes in an organic solvent and heating the resulting mixture, the reaction proceeds smoothly even if the concentration of the halosilanes is high, so that an organopolysilsesquioxane having a high molecular weight can be obtained. The amine may be various primary to tertiary amines, for example, triethylamine, tripropylamine, triisopropylamine, diethylamine, dipropylamine, ethylamine, pyridine, ethylenediamine or aniline. The amount off amine used is usually 3 moles or less, preferably from 0.3 to 2 moles, per mole of the sum of the halosilanes.

When an amine is used, a white precipitate of the hydrochloride of the amine gradually forms when water is added dropwise to a solution of the halosilanes. When further water is added, the white precipitate dissolves. After completion of the addition of water, the reaction mixture is heated, as where no amine is added, to effect condensation.

After completion of the heating, whether an amine is used or not, the organic solvent layer is separated and then washed with water. The washing operation is particularly easy if the water contains a small amount of a salt, for example, a 0.1 to 0.5% by weight aqueous ammonium nitrate solution. The washing is repeated until the washings become neutral; and the organic solvent layer is, if necessary, dried by means of a drying agent, such as anhydrous calcium sulphate or molecular sieves, and is concentrated to dryness, or, alternatively, the organic solvent layer is concentrated to a suitable concentration and poured into a solvent in which the organopolysilsesquioxane obtained can not dissolve, for example, acetonitrile, whereby the desired organopolysilsesquioxane is obtained.

Examples of $C_1$—$C_8$ alkyltrialkoxysilanes for use in process (B) of this invention include methyltrimethoxysilane, methyltriethoxysilane, ethyltrimethoxysilane, ethyltriethoxysilane, propyltrimethoxysilane, propyltriethoxysilane, methyltripropoxysilane, ethyltripropoxysilane and butyltrimethoxysilane. Examples of alkenyltrialkoxysilanes include vinyltrimethoxysilane, vinyltriethoxysilane, vinyltripropoxysilane, propenyltrimethoxysilane, propenyltripropoxysilane, butenyltrimethoxysilane, pentenyltrimethoxysilane, allyltrimethoxysilane and allyltriethoxysilane. Examples of the optional aryltrialkoxysilane include phenyltrimethoxysilane, phenyltriethoxysilane, phenyltripropoxysilane, dimethylphenyltrimethoxysilane, ethylphenyltrimethoxysilane, trimethylphenyltrimethoxysilane, methylphenyltrimethoxysilane, propylphenyltrimethoxysilane, tetramethylphenyltrimethoxysilane, methylpropylphenyltrimethoxysilane, diethylphenyltrimethoxysilane, butylphenyltrimethoxysilane, tolyltrimethoxysilane and tolyltriethoxysilane.

Examples of the optional trialkoxysilane include trimethoxysilane, triethoxysilane and tripropoxysilane. The amounts of the alkyltrialkoxysilane, the alkenyltrialkoxysilane, the aryltrialkoxysilane and the trialkoxysilane used may be determined appropriately depending upon the proportions of the alkyl group and the alkenyl group to be bonded as the side chains of the desired organopolysilsesquioxane and upon the proportions of the aryl group and the hydrogen atom bonded as side chains, if necessary, but the amount of the alkyltrialkoxysilane used is preferably from 50 to 99 mole%, more preferably from 70 to 99 mole%, the amount of the alkenyltrialkoxysilane used is preferably from 1 to 50 mole%, more preferably from 1 to 30 mole%, the amount of the aryltrialkoxysilane used is preferably from 0 to 49 mole%, more preferably from 0 to 29 mole%, and the amount of the trialkoxysilane used is preferably from 0 to 49 mole%, more preferably from 0 to 29 mole%.

The employment of an aryltrialkoxysilane sometimes further facilitates the synthesis of the desired organopolysilsesquioxane, and the employment of a trialkoxysilane results in an improvement in physical or chemical properties of the organopolysilsesquioxane.

The same organic solvents mentioned in relation to process (A) may be used, although ketones, alcohols, esters or ethers are preferred because, when they are used, the synthesis of the desired organopolysilsesquioxane is easy. These organic solvents may be used alone or in admixture with other organic solvents.

The amount of the organic solvent used is preferably from 3 to 30 parts by volume per part by volume of the total of the alkyltrialkoxysilane, the alkenyltrialkoxysilane, the aryltrialkoxysilane and the trialkoxysilane used (these four silanes are hereinafter referred to as the "alkoxysilanes"). The same organic amines mentioned in relation to process (A) may be used, although triethylamine and diethylamine are preferred. The amount of the organic amine used depends on the kind of the organic amine, the reaction conditions and the like and cannot be defined uniquely, although it is usually from 0.05 to 3 moles per mole of the alkoxysilanes.

The amount of water added is usually from 3 to 30 moles per mole of the alkoxysilanes.

In the reaction of the alkoxysilanes, hydrolysis and condensation are effected at the same time by mixing the organic amine and water with the alkoxysilanes in the form of an organic solvent solution and heating the resulting mixed solution. The heating temperature is usually 130°C or less, although it is preferable to heat at from 60° to 120°C for from 1 to 6 hours. When heated, the mixed solution may be stirred or merely left to reflux.

After completion of the heating, the same procedure as described in relation to process (A) is followed, whereby the desired organopolysilsesquioxane is obtained.

The organopolysilsesquioxane obtained by the above-mentioned process (A) or (B) usually has a polystyrene-reduced number average molecular weight of from 3,000 to 200,000 and such good stability that it does not become insoluble even if stored for a long time, for example 1 to 3 months.

Strong absorptions are observed in the vicinity of 1,120 $cm^{-1}$ and 1,040 $cm^{-1}$ in the infrared absorption spectrum of the organopolysilsesquioxane of this invention. It is known that organopolysilsesquioxanes of the type represented by the above general formula (I) have two strong specific infrared absorption bands, due to the expansion and contraction of the Si—O—Si bond, in the vicinity of 1,135 $cm^{-1}$ and 1,040 $cm^{-1}$ [J. Polym. Sci., Vol. C—1, 83 (1963), and Japanese Patent Application Kokai No. 139,900/75]. Therefore, it is judged that the organopolysilsesquioxanes prepared by process (A) or (B) also have a structure of the above general formula (I).

The heat resistance of the organopolysilsesquioxane used in this invention varies depending upon the kinds or amounts of the alkyl group and the alkenyl group to be bonded as side chains and the aryl group and hydrogen atom to be optionally bonded, although it is usually from 600° to 650°C. The larger the amount of the alkyl group, particularly methyl group, present, the higher will be the heat resistance. The organopolysilsesquioxane of this invention also has the feature that its solution has a relatively low viscosity.

The organopolysilsesquioxane used in this invention can be crosslinked by irradiation with ionizing radiation such as an electron beam and it is possible to graft an organic polymer thereon. Therefore, it can be utilized for various purposes.

However, in order to make it possible to cross-link the organopolysilsesquioxane by irradiation with light or to enhance the rate of crosslinking by irradiation with ionizing radiation, namely its sensitivity to ionizing radiation, there may be added a compound which generates a crosslinking-reaction-active species upon irradiation with light or ionizing radiation.

The nature of the compound which generates a crosslinking-reaction-active species upon irradiation with light or ionizing radiation is not critical, and such compound which is soluble in organic solvents may be used. As the crosslinking-reaction-active species, there may be used carbon, radical, nitrene, and the like. Suitable compounds include, for example: azido compounds, such as 4,4'-diazidostilbene, *p*-phenylenebisazide, 4,4'-diazidobenzophenone, 4,4'-diazidodiphenylmethane, 4,4'-diazidochalcone, 2,6-bis(4'-azidobenzal)-4-methylcyclohexanone, 4,4'-diazidodiphenyl, 4,4'-diazido-3,3'-dimethyldiphenyl, 2,7-diazidofluorene, *p*-benzoquinonediazide or *p*-naphthaquinonediazide; carbonyl compounds, such as diactyl, benzoin, benzophenone, anthraquinone, 1,2-naphthoquinone, 1,4-naphthoquinone, β-methyl-anthraquinone, benzanthrone, violanthrone, 9-anthraldehyde, benzil, *p,p'*-dimethylaminobenzophenone, *p,p'*-tetramethyldiaminobenzophenone or chloranil; aromatic hydrocarbons, such as anthracene or chrysene; nitro compounds, such as nitrobenzene, *p*-dinitrobenzene, α-nitronaphthalene, *p*-nitrodiphenyl, 2-nitrofluorene or 5-nitroacenaphthene; nitrogen compounds, such as nitroaniline, 2-chloro-4-nitroaniline, 2,6-dichloro-4-nitroaniline, 5-nitro-2-aminotoluene or tetracyanoethylene; sulphur compounds, such as diphenyldisulphide or mercaptenedisulphide; and azo compounds, such as azobisisobutyronitrile.

Although the amount of the compound which generates crosslinking-reaction-active species is not critical, it is preferably from 0.1 to 10 parts by weight, more preferably from 0.1 to 5 parts by weight, per 100 parts by weight of the organopolysilsesquioxane. When it is less than 0.1 part by weight, the resulting silicone resin composition sometimes has insufficient sensitivity to light or ionizing radiation; when it exceeds 10 parts by weight, the resulting silicone resin composition tends to have a low heat resistance.

It is also effective to add storage stabilizers, colouring agents and similar conventional additives to the silicone resin composition.

Although the method of using the silicone resin composition of this invention is not critical, the following use method may be mentioned: In an organic solvent are dissolved the organopolysilsesquioxane, a compound which generates a crosslinking-reaction-active species upon irradiation with light or ionizing radiation, and, if necessary, additives; the resulting solution is applied onto a surface to be coated by a such means as a spinner or the like; and the coated surface is then dried.

Examples of the organic solvent, include: ketones, such as methyl ethyl ketone, methyl isobutyl ketone or diethyl ketone; ethers, such as dibutyl ether, ethylene glycol monoethyl ether or acetic ethylene glycol monomethyl ether; hydrocarbons, such as heptane, ethylbenzene or toluene; halogenated hydrocarbons, such as 1,2-dichloroethane, chlorobenzene or chloroform; alcohols, such as amyl alcohol, 2-ethylhexyl alcohol or hexanol; and esters, such as butyl acetate, ethyl propionate or ethyl valerate.

The silicone resin composition applied onto the surface to be coated can be crosslinked upon irradiation with light or ionizing radiation. That is to say, a coating film of a crosslinked organopolysilsesquioxane can be allowed to remain on specific portions of the substrate, i.e. a patterned film of a crosslinked organopolysilsesquioxane can be formed, by irradiating specific portions of the silicone resin composition coating film on the surface to be coated with light or ionizing radiation, and then dissolving and removing the unirradiated portions by means of a developer consisting of an organic solvent. As the developer, there may be used the same organic solvents as suggested above for dissolving the silicone resin composition, but the employment of the same solvents is not essential.

Since the organopolysilsesquioxane used in this invention can be crosslinked with ionizing radiation as described above, a patterned film of a crosslinked organopolysilsesquioxane can also be formed by irradiating, with ionizing radiation, specific portions of an organopolysilsesquioxane coating film formed from a solution of the organopolysilsesquioxane in an organic solvent in place of the solution of the

aforesaid silicone resin composition in an organic solvent, and then dissolving and removing the unirradiated portions by means of a developer.

The film of crosslinked organopolysilsesquioxane remaining on the surface to be coated is an excellent electrically insulating layer having a high volume resistivity, a high dielectric breakdown value, a high arc-resistance, a low dielectric constant and a low dielectric loss tangent.

It is preferable to heat-treat the crosslinked organopolysilsesquioxane after development in order to improve its physical properties and its adhesion to the surface to be coated. In particular, the frequency dependence of the dielectric constant of the crosslinked organopolysilsesquioxane as an electrically insulating layer can be reduced by heat-treatment at 250° to 450°C.

The crosslinked organopolysilsesquioxane has excellent heat resistance and substantially no weight reduction is observed on heating in nitrogen until the temperature reaches 550° to 600°C.

In addition, the crosslinked organopolysilsesquioxane is superior to polyimide resin films in its adhesion to substrates, as is clear from the Examples described hereinafter.

As described above, the organopolysilsesquioxane used in this invention is excellent as a heat-resistant surface-protecting material or electrically insulating material and is particularly suitable as a surface-protecting material or insulating material for semiconductor devices.

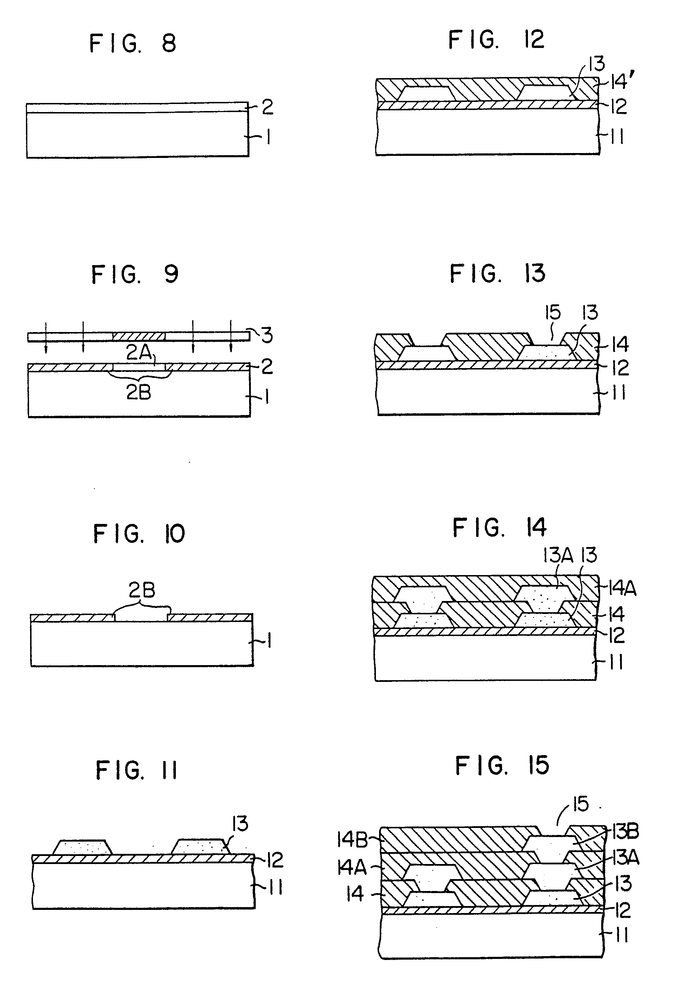

A process for producing a semiconductor device using the organopolysilsesquioxane of this invention is explained below referring to Figures 8 to 10. In the first step, an organopolysilsesquioxane layer 2 is formed by applying, by means of a spinner or the like, a solution of the organopolysilsesquioxane or the silicone resin composition in an organic solvent to the whole of the surface of a material for a semiconductor device, for example, a substrate 1 having a circuit element as shown in Figure 8, and then the solution is dried. In the second step, as shown in Figure 9, portions 2B other than the portions 2A to be removed [for example, portions in which holes for providing electrodes (hereinafter referred to as the contact holes) are to be formed] of the aforesaid layer 2 are irradiated with light or ionizing radiation, e.g. using a pattern mask 3 as shown in Figure 9, to crosslink the portions 2B and, as shown in Figure 10, the portions 2A which are not crosslinked are then dissolved and removed with a developer whereby a patterned layer of the crosslinked organopolysilsesquioxane is formed. In the manner described above, a semiconductor device having a patterned layer obtained by crosslinking the organopolysilsesquioxane is produced. Said process for producing a semiconductor device enables easy production of a semiconductor device having the desired patterned surface-protecting layer or electrically insulating layer without requiring troublesome steps and is particularly suitable for producing a semiconductor device having an electrically insulating layer between wiring layers in a multi-layer wiring structure and a surface-protecting layer for a circuit element. In contrast, the conventional process for producing a semiconductor device comprises forming a thin layer from a surface-protecting material or electrically insulating material composed of an inorganic material (such as glass) or an organic material (such as a polyamide resin) thereafter forming a photoresist film, patterning the photoresist film by exposing it to light through a pattern mask and then developing it, subsequently removing the portions in which a contact hole is to be formed by etching the insulating layer according to the pattern of the photoresist film, and thereafter removing the photoresist film.

The cured organopolysilsesquioxane composition of this invention can be used as an auxiliary film for the orientation of a liquid crystal, heat-resistant paint, a modifier for organic polymer surface, and the like, as well as in a semiconductor device.

This invention is further illustrated by the following Examples.

Molecular weights in the Examples are standard polystyrene-reduced number average molecular weights which were obtained by means of a gel permeation chromatogram (GPC) (the standard polystyrene was manufactured by U.S.A. Pressure Chemical Co., Ltd.), and the measurement conditions are as follows:

Apparatus: high-temperature high-speed gel permeation chromatogram (Model 150—C ALC/GPC) manufactured by Waters Co., Ltd. in the U.S.A.

Column: SHODEX A—8M of length 50 cm manufactured by Showa Denko Co., Ltd.

Measurement temperature: 40°C

Flow rate: 1 $cm^3$/min

Solvent: tetrahydrofuran

Concentration: silicone resin (1 g)/tetrahydrofuran (100 ml).

## Example 1

Dioxane (175 ml, 2.05 moles) was placed in a reactor equipped with a reflux condenser, a dropping funnel and a stirrer, and triethylamine (14 ml, 0.1 mole) was added to the dioxane, followed by $CH_3SiCl_3$ (15 ml, 0.125 mole), $C_6H_5SiCl_3$ (2 ml, 0.013 mole) and $CH_2{=}CHSiCl_3$ (8 ml, 0.063 mole).

Water (40 ml, 2.22 moles) was slowly dropped, with stirring, into the mixture, while the reactor was cooled with ice. The solution temperature at this time was 15° to 30°C. A white precipitate of triethylamine hydrochloride gradually formed, but this dissolved on further addition of water.

After completion of the addition of water, the reaction mixture was heated, with stirring, for 2 hours in an oil bath at 100°C. After completion of the reaction, the organic solvent layer was separated, washed with water until the washings became neutral, and then dried over anhydrous calcium sulphate. Thereafter, the

drying agent was filtered off, and the filtrate was evaporated to dryness to give 13 g of an organopolysilsesquioxane. The molecular weight of his organopolysilsesquioxane was 19,000, its thermal decomposition temperature in nitrogen was 590°C, and its infrared absorption spectrum was as shown in Figure 1.

Example 2

Triethylamine (14 ml, 0.1 mole), $CH_3SiCl_3$ (16 ml, 0.134 mole), $C_6H_5SiCl_3$ (4 ml, 0.025 mole) and $CH_2=CHSiCl_3$ (5 ml, 0.040 mole) were dissolved in methyl isobutyl ketone (175 ml, 1.4 moles), and water (40 ml, 2.22 moles) was added dropwise, after which the resulting mixture was subjected to hydrolysis in the same manner as in Example 1 and then heated at 100°C for 4 hours. Subsequently, the procedure described in Example 1 was repeated, to give 14 g of an organopolysilsesquioxane having a molecular weight of 10,000, a thermal decomposition temperature in nitrogen of 600°C and an infrared absorption spectrum as shown in Figure 2.

Example 3

Triethylamine (14 ml, 0.1 mole) was dissolved in methyl isobutyl ketone (170 ml, 1.36 moles), after which $CH_3SiCl_3$ (18 ml, 0.151 mole), $C_6H_5SiCl_3$ (1.3 ml, 0.008 mole) and $CH_2=CHSiCl_3$ (5.2 ml, 0.041 mole) were added thereto. Water (40 ml, 2.22 moles) was added dropwise, and the resulting mixture was subjected to hydrolysis and then heated at 100°C for 4 hours. Subsequently, the procedure described in Example 1 was repeated, to give 14 g of an organopolysilsesquioxane having a molecular weight of 50,000, a thermal decomposition temperature in nitrogen of 610°C and an infrared absorption spectrum as shown in Figure 3.

Example 4

$CH_3SiCl_3$ (24 ml, 0.201 moles), $CH_2=CHSiCl_3$ (2.2 ml, 0.017 mole) and triethylamine (15.7 ml, 0.113 mole) were dissolved in methyl isobutyl ketone (183 ml, 1.46 moles), and water (41.7 ml, 2.32 moles) was added dropwise, after which the resulting mixture was subjected to hydrolysis in the same manner as in Example 1 and then heated at 100°C for 4 hours. Subsequently, the procedure described in Example 1 was repeated, to give 13 g of an organopolysilsesquioxane having a molecular weight of 40,000, a thermal decomposition temperature in nitrogen of 650°C and an infrared absorption spectrum as shown in Figure 4.

Example 5

Triethylamine (28 ml, 0.2 mole), $CH_3SiCl_3$ (39.1 ml, 0.331 mole), $CH_2=CHSiCl_3$ (3.5 ml, 0.027 mole) and $HSiCl_3$ (3 ml, 0.03 mole) were dissolved in methyl isobutyl ketone (392 ml, 3.14 moles), and water (72 ml, 4 moles) was added dropwise, after which the resulting mixture was hydrolysed in the same manner as in Example 1 and then heated at 80°C for 2 hours. Subsequently, the procedure described in Example 1 was repeated, to give 20.5 g of an organopolysilsesquioxane having a molecular weight of 14,000, a thermal decomposition temperature in nitrogen of 625°C and an infrared absorption spectrum as shown in Figure 5.

Example 6

In a reactor equipped with a reflux condenser, a stirrer and a dropping funnel, triethylamine (1.5 ml, 0.088 mole), $CH_3Si(OCH_3)_3$ (40 ml, 0.279 mole), $CH_2=CHSi(OCH_3)_3$ (5.3 ml, 0.035 mole) and $C_6H_5Si(OCH_3)_3$ (6.5 ml, 0.035 mole) were dissolved in methyl isobutyl ketone (363 ml, 2.9 moles), and water (67.5 ml, 3.75 moles) was added dropwise to the resulting solution. During this procedure, the solution temperature was about 25°C and substantially no heat generation was observed. After addition of water was complete, the reaction mixture was heated, with stirring, at 80°C for 4 hours. After completion of the reaction, the organic solvent layer was separated, washed with water until the washings became neutral and then dried over anhydrous calcium sulphate. Thereafter, the drying agent was removed, and the residue was evaporated to dryness, to give 17 g of an organopolysilsesquioxane having a molecular weight of 22,000 and a thermal decomposition temperature in nitrogen of 605°C. Its infrared absorption spectrum was as shown in Figure 6.

Example 7

Triethylamine (10.3 ml, 0.079 mole), $CH_3Si(OCH_3)_3$ (40 ml, 0.279 mole) and $CH_2=CHSi(OCH_3)_3$ (4.8 ml, 0.031 mole) were dissolved in methyl isobutyl ketone (356 ml, 2.84 moles), and water (60 ml, 3.33 moles) was added dropwise thereto. After addition of water was complete, the resulting mixture was heated and stirred at 80°C for 2 hours. The same post-treatment as in Example 6 was carried out to give 15 g of an organopolysilsesquioxane having a molecular weight of 24,000 and a thermal decomposition temperature in nitrogen of 640°C. Its infrared absorption spectrum was as shown in Figure 7.

Example 8

Each of the organopolysilsesquioxanes obtained in Example 1 to 7 was dissolved in each of methyl isobutyl ketone, dioxane and toluene; all of them were soluble in all the solvents.

The organopolysilsesquioxanes obtained in Examples 1 to 7 were dissolved in 4-methyl-2-pentanol to prepare a 20% by weight solution, and this was stored at 8°C for 2 months. Consequently, it was found that the viscosity change was 10% or less.

Example 9

The nuclear magnetic resonance spectra of the organopolysilsesquioxanes obtained in Examples 1 to 7 were measured, and as a result, signals due to each of the methyl group, the hydrogen atom, the vinyl group and the phenyl group were observed at $\delta = 0.05$ (singlet), $\delta = 4.8—5.0$ (singlet), $\delta = 6.07$ (singlet) and $\delta = 7.20—8.00$ (multiplet), respectively. By integration of these absorptions, the proportions of organic groups as the side chains of each of the organopolysilsesquioxane of Examples 1 to 7 were obtained. The results are shown in the following Table.

TABLE

| Sample | Methyl group | Vinyl group | Phenyl group | Hydrogen atom |
|---|---|---|---|---|
| Example 1 | 63 | 29 | 8 | — |
| Example 2 | 68 | 20 | 12 | — |
| Example 3 | 76 | 20 | 4 | — |
| Example 4 | 93 | 7 | — | — |
| Example 5 | 85 | 7 | — | 8 |
| Example 6 | 80 | 10 | 10 | — |
| Example 7 | 90 | 10 | — | — |

Example 10

In a reaction vessel equipped with a reflux condenser, a stirrer and a dropping funnel, triethylamine (14 ml, 0.1 mole), butyltrichlorosilane (27 ml, 0.161 mole), phenyltrichlorosilane (1.5 ml, 0.010 mole) and vinyltrichlorosilane (3.8 ml, 0.030 mole) were dissolved in methyl isobutyl ketone (175 ml, 1.4 mole), and water (40 ml, 2.22 mole) was added dropwise, after which the resulting mixture was hydrolysed as described in Example 1 and heated at 100°C for 4 hours. Subsequently, the procedure described in Example 1 was repeated, to give 17 g of an organopolysilsesquioxane having a molecular weight.of 10,000 and a thermal decomposition temperature in nitrogen of 580°C. The infrared spectrum of the organopolysilsesquioxane was similar to those of the organopolysilsesquioxanes of Examples 1 to 7 and showed characteristic organopolysilsesquioxane absorption bands in the vicinity of 1130 $cm^{-1}$ and 1040 $cm^{-1}$. The nuclear magnetic resonance spectrum of the product showed the signals of the butyl group, the phenyl group and the vinyl group. In the side chains of the organopolysilsesquioxane, butyl, phenyl and vinyl groups were present in a proportion of 79:5:16.

Example 11

Triethylamine (14 ml, 0.1 mole), methyltrichlorosilane (19 ml, 0.161 mole), allyltrichlorosilane (4.3 ml, 0.030 mole) and phenyltrichlorosilane (1.5 ml, 0.010 mole) were dissolved in methyl isobutyl ketone in the same reaction vessel as in Example 10, and water (40 ml, 2.22 mole) was added dropwise, after which the resulting mixture was hydrolysed as described in Example 1, and then heated at 110°C for 2 hours. Subsequently, the procedure described in Example 1 was repeated, to give 14 g of an organopolysilsesquioxane having a molecular weight of 13,000 and a thermal decomposition temperature in nitrogen of 590°C. The infrared spectrum of the organopolysilsesquioxane was similar to those of the organopolysilsesquioxanes of Examples 1 to 7 and showed characteristic organopolysilsesquioxane absorption bands in the vicinity of 1,135 $cm^{-1}$ and 1,040 $cm^{-1}$. The nuclear magnetic resonance spectrum of the product was measured, and as a result, signals due to each of the methyl group, the allyl group and the phenyl group were observed. In the side chains of the organopolysilsesquioxane, methyl phenyl and allyl groups were present in a proportion of 80:5:15.

Example 12

Triethylamine (14 ml, 0.1 mole), methyltrichlorosilane (19 ml, 0.161 mole), *p*-tolyltrichlorosilane (1.5 ml, 0.010 mole) and vinyltrichlorosilane (3.8 ml, 0.030 mole) were dissolved in methyl isobutyl ketone (175 ml, 1.4 mole) in the same vessel as in Example 10, and water was added dropwise, after which the resulting mixture was hydrolysed as described in Example 1 and then heated at 100°C for 2 hours. Subsequently, the procedure described in Example 1 was repeated, to give 14 g of an organopolysilsesquioxane having a molecular weight of 15,000 and a thermal decomposition temperature in nitrogen of 590°C. The infrared spectrum of the organopolysilsesquioxane was similar to those of the organopolysilsesquioxanes of Examples 1 to 7 and showed characteristic organopolysilsesquioxane absorption bands in the vicinity of 1,130 $cm^{-1}$ and 1,040 $cm^{-1}$. The nuclear magnetic resonance spectrum of the organopolysilsesquioxane showed the signals of the methyl group, the *p*-tolyl group and the vinyl group. In the side chains of the organopolysilsesquioxane, methyl, *p*-tolyl and vinyl groups were present in a proportion of 81:5:14.

Example 13

The organopolysilsesquioxane (5 g) obtained in Example 3 was dissolved in butyl acetate to prepare a 20% by weight solution, and 2,6-bis(4'-azidobenzal)-4-methylcyclohexanone (0.15 g) was added thereto, to prepare a solution of a silicone resin composition. This solution was applied to a silicone wafer of 2 inches (50.8 mm) diameter by a spin coating method at 4,000 r.p.m. and then heated at 80°C for 15 minutes to remove the solvent, whereby a thin film (thickness: about 1 μm) of the silicone resin composition was formed. The thin film was exposed to light through a pattern mask for 6 seconds by means of an exposing machine (manufactured by Mikasa Co., Ltd.; an ultra-high pressure mercury lamp, output 43 $W/m^2$), and then developed by immersion of the silicone wafer in ethylene glycol monoethyl ether for 1 minute to obtain a clear pattern of 5 μm.

A coating film of the silicone resin composition was separately prepared from the solution of the silicone resin by a casting method, and the whole surface of the coating film was exposed to light as above by means of the aforesaid exposure machine. Subsequently, the coating film was heated in a nitrogen stream at 250°C for 2 hours, at 350°C for 1 hour, and then at 450°C for 30 minutes, in which no weight loss was observed up to 600°C and the percentage of residual weight after further heating the coating film to 800°C to calcine the same was 95%.

Example 14

In the same manner as in Example 1, 13 g of a polysilsesquioxane was prepared from 15.7 ml (0.113 mole) of triethylamine, 24 ml (0.201 mole) of $CH_3SiCl_3$, 2.2 ml (0.017 mole) of $CH_2{=}CHSiCl_3$, 183 ml (1.46 mole) of methyl isobutyl ketone and 41.7 ml (2.32 moles) of water. Its molecular weight was 40,000. The proportions of organic groups as its side chains were measured in the same manner as in Example 9 to find that the proportion of methyl groups was 93 and that of vinyl groups was 7.

Subsequently, this polysilsesquioxane (5 g) was dissolved in a solvent and the solution was applied by a spin coating method, exposed and developed in the same manner as in Example 13, to give a clear pattern of 5.0 μm. A coating film of a silicone resin composition was obtained in the same manner as in Example 13, and subjected to thermogravimetric analysis as in Example 13 to find that no weight loss was observed up to 600°C and that the percentage of residual weight was 96%.

Example 15

As shown in Figure 11, there was prepared a semiconductor substrate 11 which had a circuit element and was coated with a protective film 12 consisting of $SiO_2$ and the like so that the predetermined portions of its surface were exposed. An aluminium wiring layer 13 of about 1 μm thickness and having a predetermined pattern was formed on the circuit element side. Subsequently, as shown in Figure 12, the silicone resin composition solution prepared in Example 14 was applied to the whole of the exposed surface by means of a spinner at a revolution rate of 4,000 r.p.m. and then heated at a temperature of 80°C for 15 minutes to remove the solvent, whereby a thin film 14' of the silicone resin composition of about 1 μm thickness was formed. The thin film 14' was exposed to light through a pattern mask for 6 seconds by means of an exposing machine (manufactured by Mikasa Co., Ltd.) equipped with an ultra-high pressure mercury lamp having an output of 43 $W/m^2$. Thereafter, the uncrosslinked portions were dissolved and removed by immersing the semiconductor substrate in ethylene glycol monoethyl ether for 1 minute, whereby a patterned insulating layer 14 having contact holes 15 was formed as shown in Figure 13. Subsequently, the insulating layer 14 was heat-treated in a nitrogen stream at a temperature of 250°C for 2 hours and then at a temperature of 350°C for 1 hour.

By repeating the same steps as above from the formation of the aluminium wiring layer, the second wiring layer 13A and the second insulating layer 14A were formed as shown in Figure 14, and the third wiring layer 13B and the third insulating layer 14B were further formed as shown in Figure 15, whereby a semiconductor device was produced.

Example 16

Using the silicone resin composition solution prepared in Example 14, the same procedure as in Example 15 was repeated to produce a semiconductor device having patterned insulating layers 14, 14A and 14B and having contact holes 15 as shown in Figure 15.

Example 17

This Example examines a crosslinked organopolysilsesquioxane layer for adhesion.

A silicone wafer on which a $SiO_2$ coating film had been formed and an aluminium plate were used as substrates, and the same silicone resin composition solution as was used in each of Examples 13 and 14 was applied to each substrate by means of a spinner, to form a thin film. The thin film was heated at 100°C for 1 hour to remove the solvent, after which the whole surface of the thin film was exposed to light for 6 seconds by means of the same exposing machine as described in Example 13. The thin film was then

heated at 250°C for 2 hours, at 350°C for 1 hour and then at 450°C for 30 minutes, all in a nitrogen stream. Each of the thus obtained silicone wafers and aluminium plates coated with the thin film was immersed in water in an autoclave and heated for 2 hours in an oil bath maintained at a temperature of 110°C. Thereafter, notches were made lengthwise and widthwise at intervals of 1 mm on the aforesaid thin film by means of a razor to form 100 squares of 1 mm × 1 mm. Then an adhesive cellophane tape was attached to the squares and then peeled off, the squares were not peeled from the silicone wafer or the aluminium plate. On the other hand, a polyimide resin (PIQ manufactured by Hitachi Chemical Co., Ltd.) dissolved in *N*-methyl-2-pyrrolidone was applied by means of a spinner to a silicone wafer on which a $SiO_2$ coating film had been formed, and heated at a temperature of 100°C for 1 hour to remove the solvent, and the thin film was subsequently heated at a temperature of 200°C for 1 hour and then at 350°C for 1 hour both in a stream of nitrogen, and treated in water under the same conditions as described above, after which the same peeling-off test as above was carried out to find that all the squares were peeled off.

**Claims**

1. A composition comprising:
(a) an organopolysilsesquioxane represented by the formula (I):

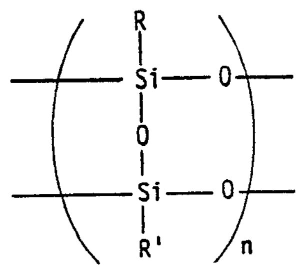

(I)

wherein R and R′, which may be the same or different, each represents a hydrogen atom, a $C_1$—$C_8$ alkyl group, an alkenyl group or an aryl group, and *n* is a degree of polymerisation, characterised in that some of the groups represented by R and/or R′ are $C_1$—$C_8$ alkyl groups, some of the groups represented by R and/or R′ are alkenyl groups and optionally other R and/or R′ represent aryl groups and/or hydrogen atoms and the proportions of said alkyl groups, alkenyl groups, aryl groups and hydrogen atoms bonded as side chains are from 50 to 99, from 1 to 50, from 0 to 49 and from 0 to 49, respectively, per 100 side chains and
(b) a compound which generates a cross-linking-reacting-active species upon irradiation with light or ionizing radiation.

2. A composition according to Claim 1, wherein said alkyl groups have from 1 to 5 carbon atoms; said alkenyl groups have from 2 to 5 carbon atoms; and said aryl groups have 6 to 10 carbon atoms.

3. A composition according to Claim 1, wherein said alkyl groups are methyl groups and said alkenyl groups are vinyl groups.

4. A composition according to any one of the preceding Claims, wherein *n* has a value corresponding to a polystyrene-reduced number average molecular weight of 3,000 to 200,000.

5. A composition according to any one of the preceding Claims, wherein said compound is an azido compound, a carbonyl compound, an aromatic hydrocarbon, a nitro compound, a nitrogen compound, a sulphur compound, or an azo compound.

6. A composition according to any one of the preceding Claims, wherein the amount of said compound is from 0.1 to 10 parts by weight per 100 parts by weight of said organopolysilsesquioxane.

**Patentansprüche**

1. Zusammensetzung, enthaltend
(a) ein Organopolysilsesquioxan der Formel (I)

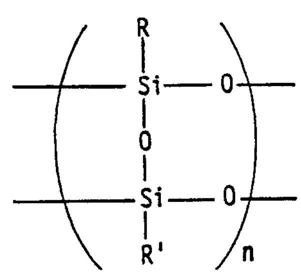

(I)

in der R und R′, gleich oder verschieden, je ein Wasserstoffatom, einen $C_{1-8}$ Alkylrest, einen Alkenyl- oder

Arylrest und n den Polymerisationsgrad bedeuten, dadurch gekennzeichnet, daß einige Gruppen R und/oder R' $C_{1-8}$ Alkylgruppen sind, einige der Gruppen R und/oder R' Alkenylgruppen und gegebenenfalls andere Gruppen R und/oder R' Arylgruppen und/oder Wasserstoffatome sind und das Verhältnis von Alkyl-, Alkenyl-, Arylgruppen und an Seitenketten gebundenen Wasserstoffatomen von 50 bis 99, von 1 bis 50, von 0 bis 49 bzw. 0 bis 49 je 100 Seitenketten beträgt, und

(b) eine Verbindung, die nach Bestrahlung mit Licht oder ionisierenden Strahlen eine Vernetzungsreaktion fördernde Verbindung freisetzt.

2. Zusammensetzung nach Anspruch 1, in der die Alkylgruppen von 1 bis 5 Kohlenstoffatome, die Alkenylgruppen von 2 bis 5 Kohlenstoffatome und die Arylgruppen 6 bis 10 Kohlenstoffatome aufweisen.

3. Zusammmensetzung nach Anspruch 1, in der die Alkylgruppen Methylgruppen und die Alkenylgruppen Vinylgruppen sind.

4. Zusammensetzung nach einem der vorstehenden Ansprüche, in der n einen Wert hat, der einem Polystyrol-reduzierten Zahlenmittel der Molekülmasse von 3000 bis 200 000 entspricht.

5. Zusammensetzung nach einem der vorstehenden Ansprüche, in der die Verbindung eine Azido- oder Carbonylverbindung, ein aromatischer Kohlenwasserstoff, eine Nitro-, Stickstoff-, Schwefel- oder Azoverbindung ist.

6. Zusammensetzung nach einem der vorstehenden Ansprüche, in der die Menge der Verbindung von 0,1 bis 10 Masseteilen je 100 Masseteile Organopolysilsesquioxan beträgt.

## Revendications

1. Composition comprenant:

(a) un organopolysilsesquioxane de formule (I):

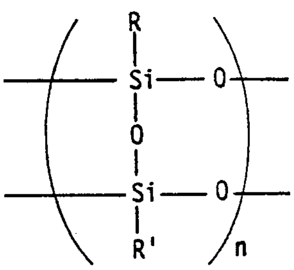

(I)

dans laquelle les groupes R et R' représentent chacun un atome d'hydrogène, un groupe alkyle en $C_1$—$C_8$, un groupe alkényle ou un groupe aryle, et n représente un degré de polymérisation, caractérisée en ce que certains des groupes représentés par R et/ou R' sont des groupes alkyle en $C_1$—$C_8$, certains des groupes représentés par R et/ou R' sont des alkényle, et d'autres groupes R et/ou R' représentent éventuellement des groupes aryle et/ou des atomes d'hydrogène, et les proportions desdits groupes alkyle, alkényle, aryle et des atomes d'hydrogène présents comme chaînes latérales, sont respectivement de 50 à 99, de 1 à 50, de 0 à 49, et de 0 à 49 pour 100 chaînes latérales; et en ce qu'elle comprend:

(b) un composé produisant des dérivés actifs dans une réaction de réticulation par irradiation avec de la lumière ou un rayonnement ionisant.

2. Composition suivant la revendication 1 dans laquelle les groupes alkyle comportent de 1 à 5 atomes de carbone, les groupes alkényle comportent de 2 à 5 atomes de carbone, et les groupes aryle comportent de 6 à 10 atomes de carbone.

3. Composition suivant la revendication 1, dans laquelle les groupes alkyle sont des groupes méthyle, et les groupes alkényle sont des groupes vinyle.

4. Composition suivant l'une quelconque des revendications précédentes, dans laquelle n a une valeur correspondant à un poids moléculaire moyen en nombre étalonné par rapport au polystyrène de 3 000 à 200 000.

5. Composition suivant l'une quelconque des revendications précédentes, dans laquelle ledit composé est un composé de type azido, un composé carbonylé, un hydrocarbure aromatique, un composé nitré, un composé azoté, un composé sulfuré ou un composé azoïque.

6. Composition suivant l'une quelconque des revendications précédentes, dans laquelle la quantité dudit composé est de 0,1 à 10 parties en poids pour 100 parties en poids dudit organopolysilsesquioxane.

FIG. 1

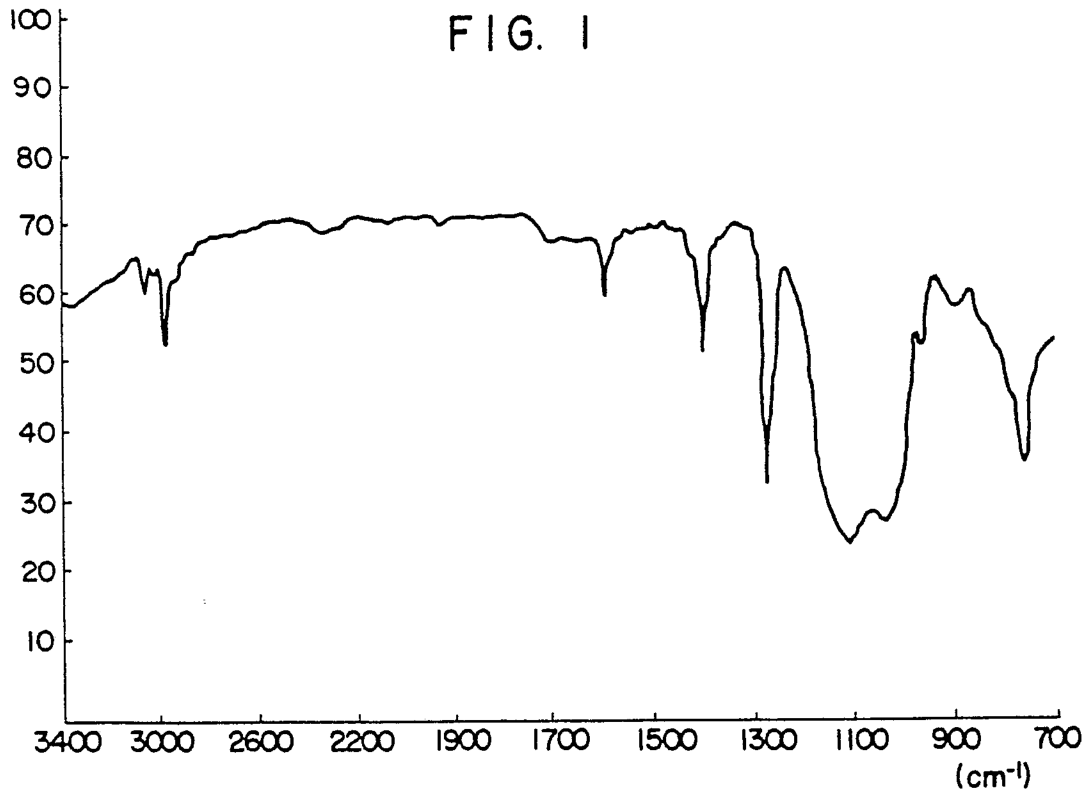
100
90
80
70
60
50
40
30
20
10
3400
3000
2600
2200
1900
1700
1500
1300
1100
900
700
(cm-1)

FIG. 2

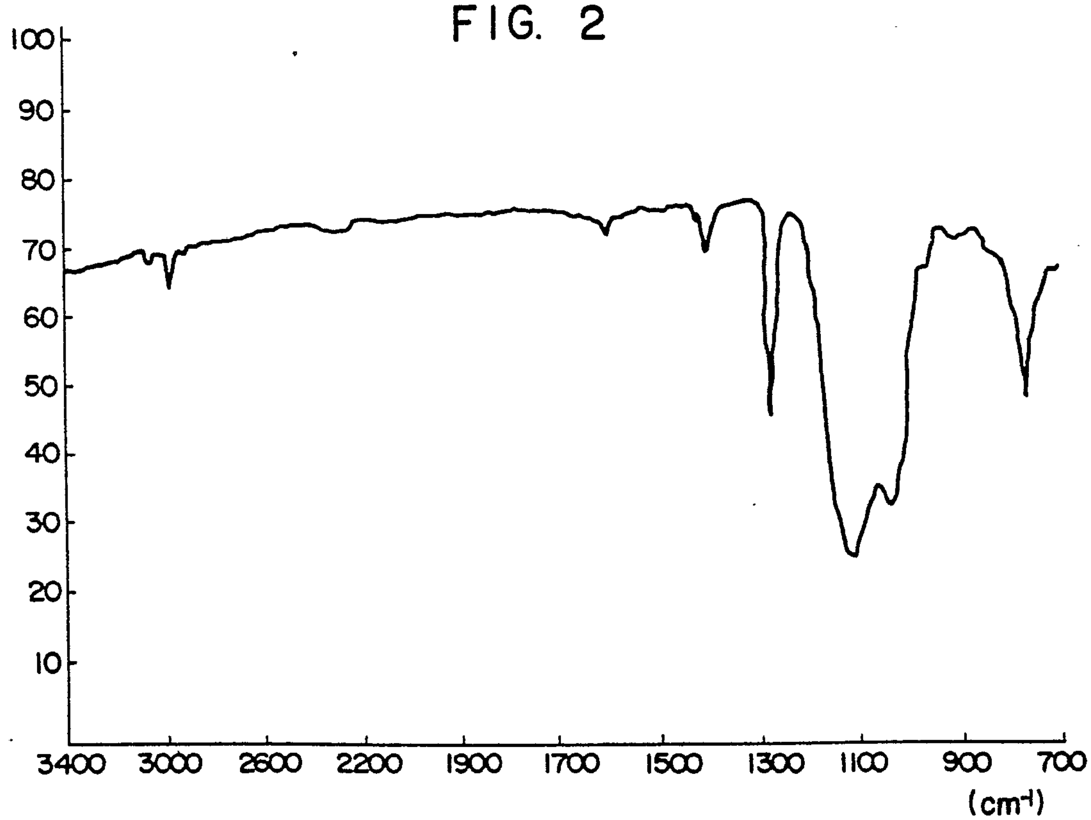
100
90
80
70
60
50
40
30
20
10
3400
3000
2600
2200
1900
1700
1500
1300
1100
900
700
(cm-1)

FIG. 3

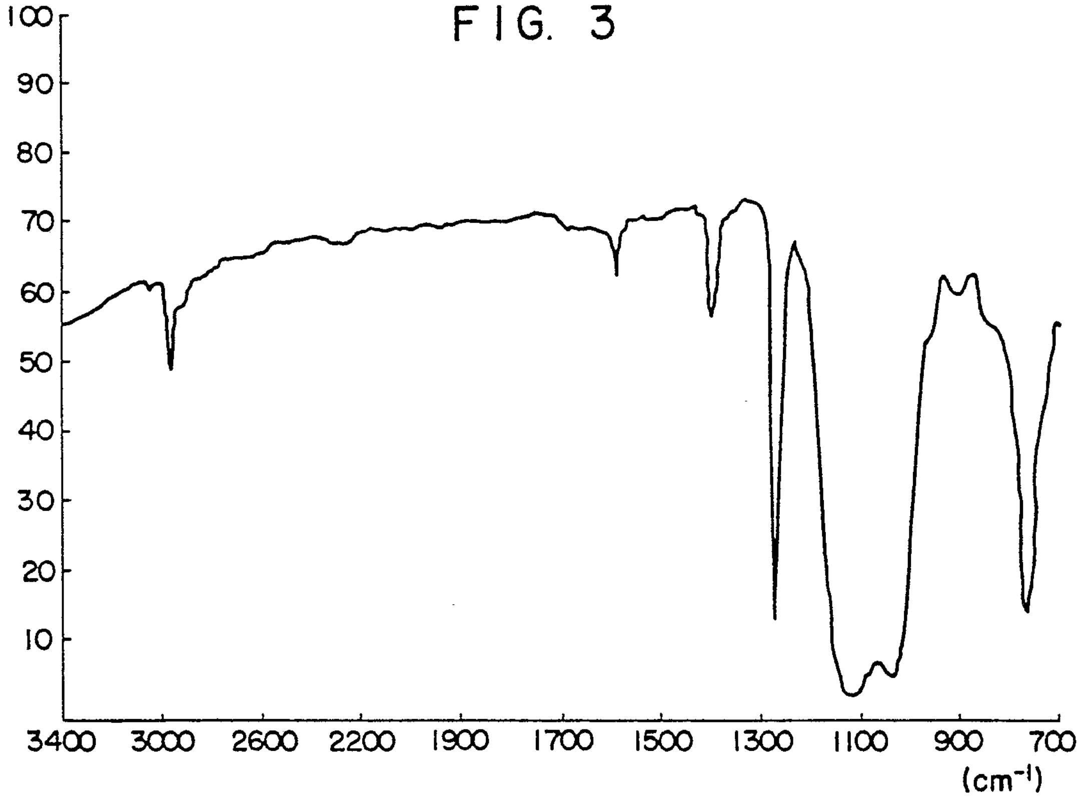
100
90
80
70
60
50
40
30
20
10
3400
3000
2600
2200
1900
1700
1500
1300
1100
900
700
(cm⁻¹)

FIG. 4

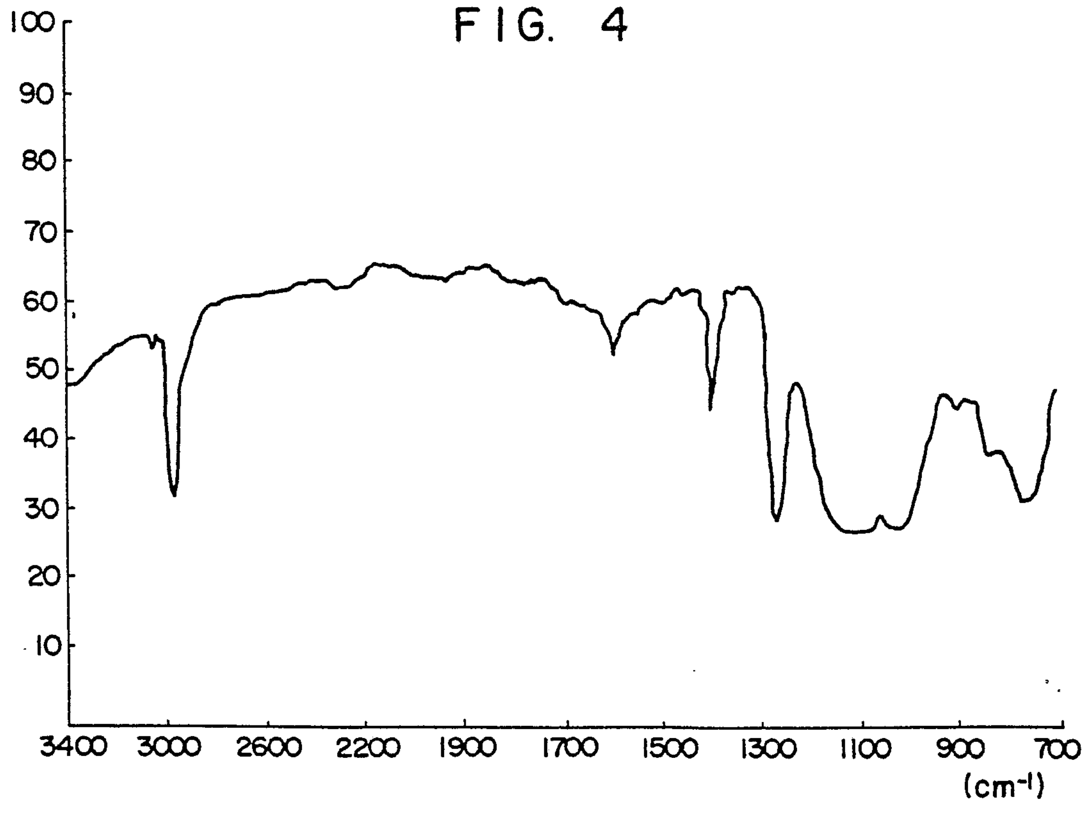
100
90
80
70
60
50
40
30
20
10
3400
3000
2600
2200
1900
1700
1500
1300
1100
900
700
(cm⁻¹)

FIG. 5

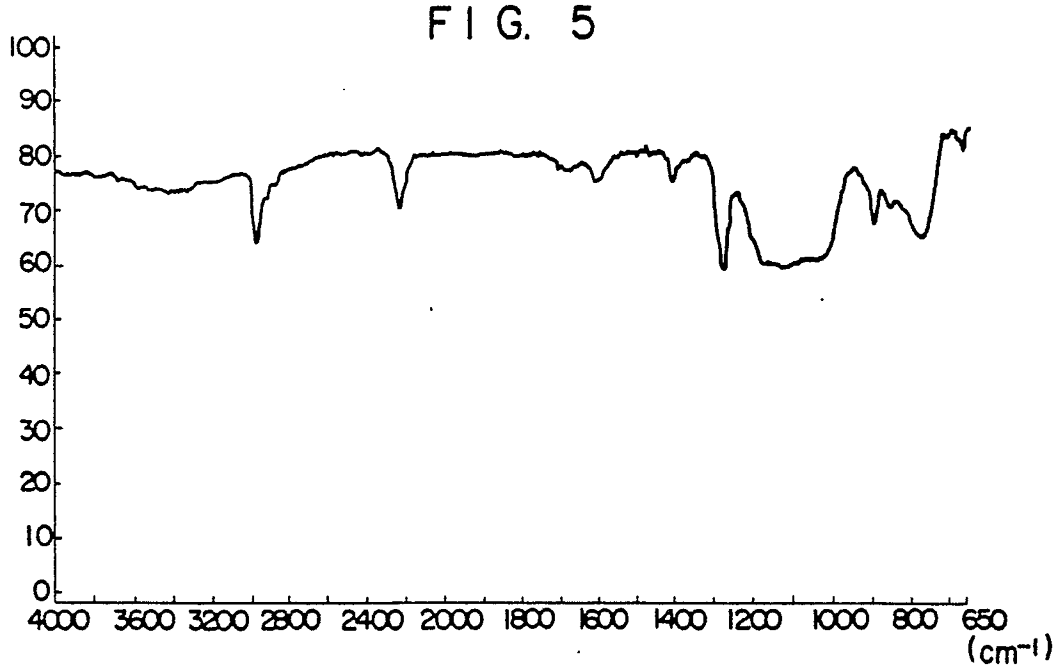
100
90
80
70
60
50
40
30
20
10
0
4000
3600
3200
2800
2400
2000
1800
1600
1400
1200
1000
800
650
(cm-1)

FIG. 6

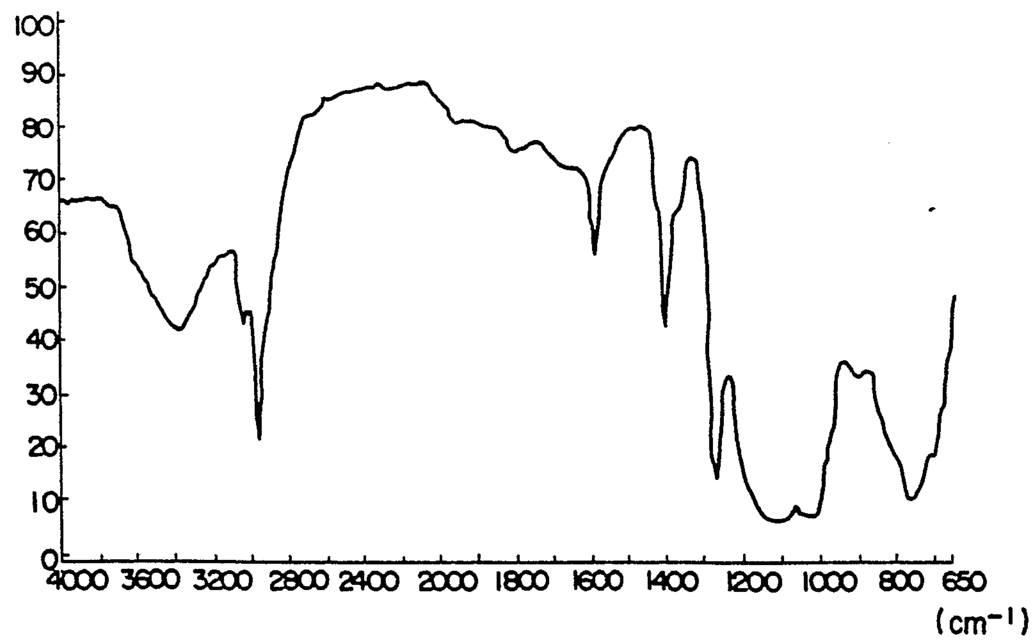
100
90
80
70
60
50
40
30
20
10
0
4000
3600
3200
2800
2400
2000
1800
1600
1400
1200
1000
800
650
(cm-1)

FIG. 7

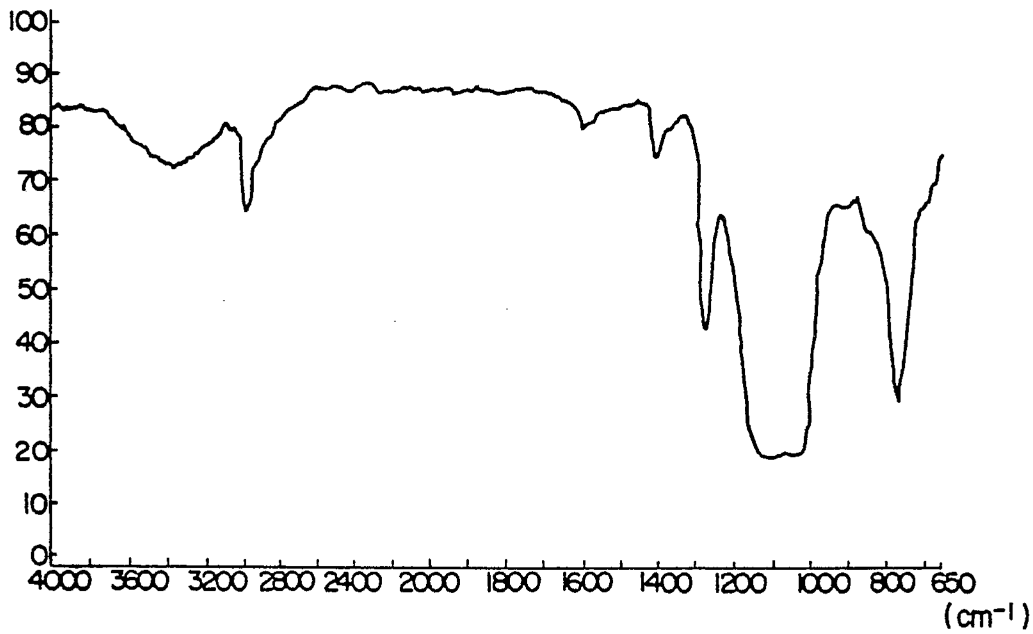
100
90
80
70
60
50
40
30
20
10
0
4000
3600
3200
2800
2400
2000
1800
1600
1400
1200
1000
800
650
(cm⁻¹)

FIG. 8

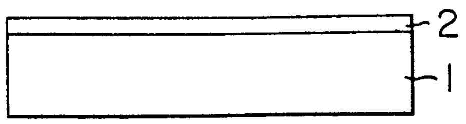


FIG. 9

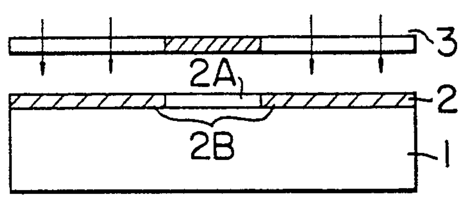


FIG. 10

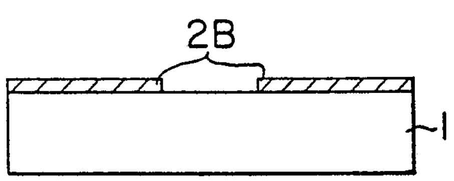


FIG. 11

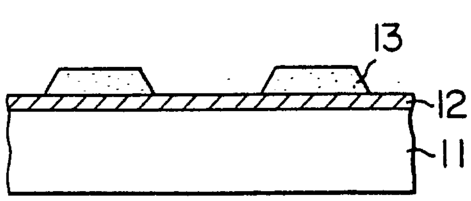


FIG. 12

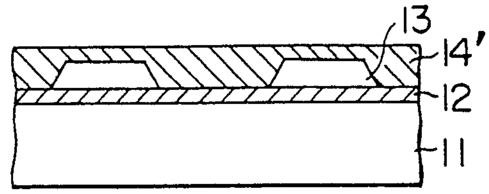


FIG. 13

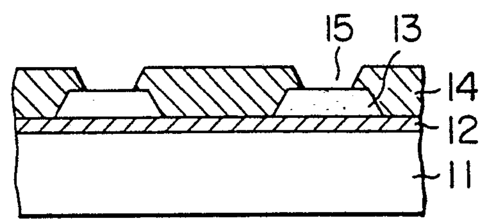


FIG. 14

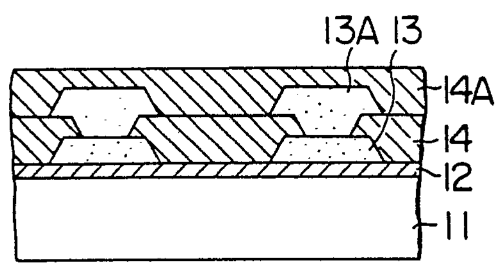


FIG. 15